# EUROPEAN PATENT APPLICATION

(11) **EP 4 480 986 A1**
(43) Date of publication of application: **25.12.2024**
(21) Application number: 23756303.6
(22) Date of filing: 13.02.2023
(51) Int. Cl.: C08G 63/64

(54) **CURABLE RESIN, CURED PRODUCT OF SAME, AND RESIN COMPOSITION**

(30) Priority: 16.02.2022 JP 2022021980
(71) Applicant: MITSUBISHI GAS CHEMICAL COMPANY, INC., Chiyoda-ku Tokyo 100-8324 (JP)
(72) Inventor: KODA, Aiko, Hiratsuka-shi, Kanagawa 254-0016 (JP); YONEHAMA, Shinichi, Hiratsuka-shi, Kanagawa 254-0016 (JP); NAGAI, Masayuki, Hiratsuka-shi, Kanagawa 254-0016 (JP)
(74) Representative: Müller-Boré & Partner Patentanwälte PartG mbB
(86) International application number: PCT/JP2023/004675
(87) International publication number: WO 2023/157778

(57) **Abstract**

A curable resin containing:
a structural unit represented by the following formula (1): 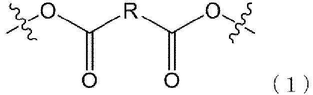 wherein R is a divalent group having an ethylenic double bond and/or an acetylenic triple bond;
a structural unit represented by the following formula (2): 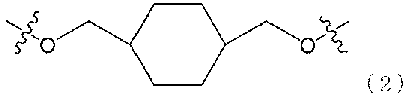 and a structural unit represented by the following formula (3):

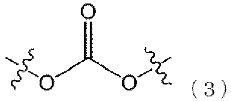

## Description

### Technical Field

The present invention relates to a curable resin, a cured product thereof, and a resin composition.

### Background Art

Polycarbonate resins are used in various applications due to having excellent mechanical strength, heat resistance, transparency, etc., and various types of polyester carbonates and production methods thereof have been reported.

For example, Patent Literature 1 discloses "a method for producing an aliphatic polyester carbonate having a weight average molecular weight of 100,000 or more, comprising the steps of: polycondensing a reaction product obtained from a reaction of maleic anhydride, a glycol having 2 to 20 carbon atoms, a diluent, and hydrogen in the presence of a hydrogeneration catalyst to produce an aliphatic polyester oligomer having a number average molecular weight of 200 to 5,000 in the presence of a transesterification catalyst; and then reacting the aliphatic polyester oligomer and a carbonic acid diester."

Further, Patent Literature 2 discloses "a polyester resin C comprising a hard segment based on an ester bond-containing diol oligomer A1 having at least two or more ester bonds and a hydroxyl group at both ends, a soft segment based on a carbonate group-containing diol oligomer A2 having at least two or more carbonate groups and a hydroxyl group at both ends, and a residual carboxyl group-containing segment B based on an acid dianhydride."

### Citation List

### Patent Literature

Patent Literature 1
   Japanese Patent Laid-Open No. 2003-2959
Patent Literature 2
   Japanese Patent Laid-Open No. 2010-13527

### Summary of Invention

### Technical Problem

Although various types of polyester carbonates are known as described above, the polyester carbonates have low compatibility with a curable resin, and therefore are difficult to add to the curable resin. Further, there is room for improvement in the properties of conventional polyester carbonates. Accordingly, an object of the present invention is to provide a curable resin having high strength.

### Solution to Problem

As a result of extensive studies, the present inventors have found that a curable resin having high strength can be obtained by reacting a dicarboxylic acid compound having a specific structure, a diol compound, and a carbonate compound.

The present invention includes the following embodiments.
[1] A curable resin comprising:
   a structural unit represented by the following formula (1): 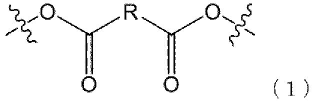
   wherein R is a divalent group having an ethylenic double bond and/or an acetylenic triple bond,
   a structural unit represented by the following formula (2): 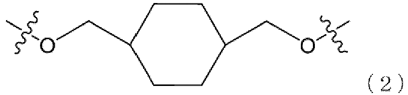
   and a structural unit represented by the following formula (3): 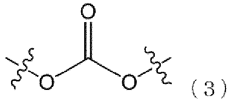
[2] The curable resin according to item [1], wherein the structural unit represented by the formula (1) is derived from at least one selected from the group consisting of fumaric acid, maleic acid and maleic anhydride.
[3] The curable resin according to item [1] or [2], having a glass transition temperature of 50°C or less.
[4] The curable resin according to any one of items [1] to [3], wherein a molar ratio of the structural unit represented by the formula (1) to the structural unit represented by the formula (2) is 0.01 or more and less than 1.
[5] The curable resin according to any one of items [1] to [4], wherein a molar ratio of the structural unit represented by the formula (3) to the structural unit represented by the formula (2) is 0.01 or more and less than 1.
[6] The curable resin according to any one of items [1] to [5], wherein a molar ratio of the total of the structural unit represented by the formula (1), the structural unit represented by the formula (2) and the structural unit represented by the formula (3) to all the structural units constituting the curable resin is 0.6 or more.
[7] The curable resin according to any one of items [1] to [6], further comprising a structural unit represented by the following formula (4): 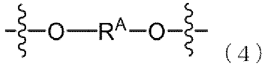 wherein R^{A} is a straight chain alkylene group.
[8] A cured product of the curable resin according to any one of items [1] to [7].
[9] A resin composition comprising the curable resin according to any one of items [1] to [7].
[10] The resin composition according to item [9], wherein the amount of the curable resin relative to 100 parts by mass of the resin component contained in the resin composition is 1.0 part by mass or more.
[11] The resin composition according to item [9] or [10], for use as an electronic material.
[12] An electronic component comprising a cured product of the resin composition according to item [9] or [10].
[13] A fiber-reinforced composite material comprising the resin composition according to item [9] or [10] and a reinforcement fiber.
[14] A fiber-reinforced formed article being a cured product of the fiber-reinforced composite material according to item [13].
[15] A semiconductor sealing material comprising the resin composition according to item [9] or [10] and an inorganic filler.
[16] A semiconductor device comprising a cured product of the semiconductor sealing material according to item [15] .
[17] A prepreg comprising a base material and the resin composition according to item [9] or [10] that is impregnated into or applied to the base material.
[18] A laminate comprising the prepreg according to item [17] .
[19] A circuit board comprising the laminate according to item [18] and a metal foil disposed on one or both surfaces of the laminate.
[20] A buildup film comprising a cured product of the resin composition according to item [9] or [10] and a base material film.

### Advantageous Effect of Invention

According to the present invention, a curable resin having high strength can be provided.

### Description of Embodiments

Hereinafter, embodiments of the present invention are described in detail. The present invention, however, is not limited thereto, and may be variously modified without departing from the scope of the gist.

### <Curable resin>

An embodiment of the present invention relates to a curable resin having:
a structural unit represented by the following formula (1) (hereinafter also referred to as "dicarboxylic acid unit"): 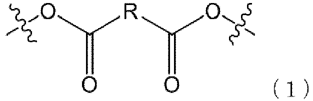
wherein R is a divalent group having an ethylenic double bond and/or an acetylenic triple bond,
a structural unit represented by the following formula (2) (hereinafter also referred to as "dihydroxy unit"): 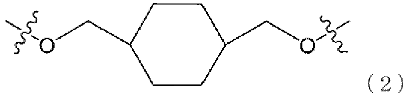
and a structural unit represented by the following formula (3) (hereinafter also referred to as "carbonate unit"):

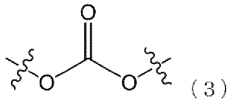

In the curable resin, although the sequence of bonds among the dicarboxylic acid unit, dihydroxy unit, and carbonate unit is not particularly limited, it is preferable that the dicarboxylic acid unit and the carbonate unit be adjacent to the dihydroxy unit. Incidentally, the oxygen atom at an end of these units is shared with the oxygen atom at an end of the neighboring unit. For example, in the case where a dicarboxylic acid unit and a dihydroxy unit are adjacent to each other, the oxygen at ends of both units is shared to form the following ester bond:

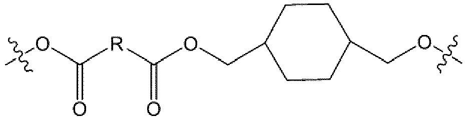

Also, in the case where a carbonate unit and a dihydroxy unit are adjacent to each other, the oxygen at ends of both units is shared to form the following carbonate bond:

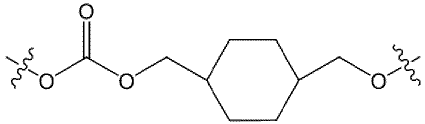

The curable resin of the present embodiment may be a random copolymer of a dicarboxylic acid unit, a dihydroxy unit and a carbonate unit. The copolymer of a carbonate unit and a dihydroxy unit may be a copolymer connected to a dicarboxylic acid unit. The copolymer of a dicarboxylic acid unit and a dihydroxy unit may be a copolymer connected to a carbonate unit.

The curable resin of the present embodiment can exhibit high strength by curing. The reason is presumed that the glass transition temperature of the curable resin is lowered due to having the dihydroxy unit represented by the formula (2), and the flexibility of the dihydroxy unit represented by the formula (2) itself is high, though the present invention is not limited at all by the presumption.

The curable resin of the present embodiment has a dicarboxylic acid unit, a dihydroxy unit and a carbonate unit. The curable resin may be any of a thermosetting resin and a photocurable resin.

In the formula (1), R is a divalent group having an ethylenic double bond and/or an acetylenic triple bond, preferably a divalent group having an ethylenic double bond, more preferably a divalent hydrocarbon group having an ethylenic double bond, still more preferably a divalent hydrocarbon group having an ethylenic double bond, with 2 to 6 carbon atoms, particularly preferably a divalent hydrocarbon group having an ethylenic double bond, with 2 to 4 carbon atoms, and most preferably a divalent hydrocarbon group having an ethylenic double bond, with 2 carbon atoms.

The dicarboxylic acid unit of which R is a divalent hydrocarbon group having an ethylenic double bond, with 2 carbon atoms is derived from at least one selected from the group consisting of fumaric acid, maleic acid and maleic anhydride.

In the present specification, "ethylenic double bond" means a carbon-carbon double bond having no aromatic ring.

In the present specification, "acetylenic triple bond" means a carbon-carbon triple bond having no aromatic ring.

Due to having an ethylenic double bond and/or an acetylenic triple bond, the curable resin of the present embodiment may be cured alone without use of a crosslinking agent.

A conventional polyester carbonate has no spot (functional group) crosslinkable with a curable resin, causing problems when added to a curable resin having low compatibility, such as phase separation and peeling at an interface with the curable resin. Although the curable resin of the present embodiment is a resin including an ester bond and a carbonate bond, it has one or more of at least one of the ethylenic double bond and the acetylenic triple bond, so that when mixed with another curable resin, the curable resin can react with a functional group of the other curable resin to make a crosslinking. Thereby, the curable resin of the present embodiment can be cured alone, and when mixed with another curable resin, phase separation and interface peeling is unlikely to occur.

The curable resin of the present embodiment may have a further structural unit in addition to a dicarboxylic acid unit, a dihydroxy unit and a carbonate unit. Although the further structural unit is not particularly limited, one having no negative impact on the high strength of the curable resin is preferred. Examples of the further structural unit include a structural unit derived from a compound having a straight chain hydrocarbon group and two hydroxy groups, and a structural unit derived from a compound having a siloxane bond and two hydroxy groups. Also, examples of the further structural unit include a structural unit derived from a dicarboxylic acid compound not applicable to the formula (1), a structural unit derived from a dihydroxy compound not applicable to the formula (2), and a monohydroxy compound having an ethylenic double bond.

Example of such a dicarboxylic acid compound include a saturated aliphatic dicarboxylic acid, an aromatic dicarboxylic acid and an acid anhydride thereof, though not particularly limited.

Examples of the saturated aliphatic dicarboxylic acid include cyclohexanedicarboxylic acid, cyclopentanedicarboxylic acid, adipic acid, succinic acid, sebacic acid, alkylsuccinic acid, cyclohexane diacetic acid, azelaic acid, malonic acid, dimethylmalonic acid and oxalic acid.

Examples of the aromatic dicarboxylic acid include terephthalic acid, isophthalic acid, 1,4-naphthalenedicarboxylic acid, 2,6-naphthalenedicarboxylic acid, 2,7-naphthalenedicarboxylic acid, biphenyldicarboxylic acid, 5-tert-butyl-1,3-benzenedicarboxylic acid, 2,5-furandicarboxylic acid, and 2,5-thiophenedicarboxylic acid.

Also, examples of such a dihydroxy compound include an aliphatic dihydroxy compound and an aromatic dihydroxy compound, though not particularly limited.

Examples of the aliphatic dihydroxy compound include ethylene glycol, 1,2-propanediol, 1,3-propanediol, 1,2-butanediol, 1,3-butanediol, 1,4-butanediol, 2,3-butanediol, 1,4-butenediol, 2-methyl-1,3-propanediol, 1,5-pentanediol, neopentyl glycol, 2-ethyl-2-methylpropane-1,3-diol, 2-butyl-2-ethylpropane-1,3-diol, 1,6-hexanediol, 3-methyl-1,5-pentanediol, 2-ethyl-1,3-hexanediol, 2,4-dimethyl-1,5-pentanediol, 2,2,4-trimethyl-1,3-pentanediol, 1,7-heptanediol, 1,8-octanediol, 1,9-nonanediol, and 1,10-decanediol.

Examples of the aromatic dihydroxy compound include hydroquinone, resorcin, 4,4'-dihydroxybiphenyl, xylylene glycol, 4,4'-dihydroxydiphenyl benzophenone, and bisphenols. Examples of bisphenols include 2,2-bis(4-hydroxyphenyl)propane, 2,2-bis(3-methyl-4-hydroxyphenyl)propane, 2,2-bis(4-hydroxy-3,5-dimethylphenyl)propane, 2,2-bis(4-hydroxy-3,5-diethylphenyl)propane, 2,2-bis(4-hydroxy-(3-phenyl)phenyl)propane, 2,2-bis(4-hydroxy-(3,5-diphenyl)phenyl)propane, 2,2-bis(4-hydroxy-3,5-dibromophenyl)propane, bis(4-hydroxyphenyl)methane, 1,1-bis(4-hydroxyphenyl)ethane, 2,2-bis(4-hydroxyphenyl)butane, 2,2-bis(4-hydroxyphenyl)pentane, 1,1-bis(4-hydroxyphenyl)-1-phenylethane, bis(4-hydroxyphenyl)diphenylmethane, 1,1-bis(4-hydroxyphenyl)-2-ethylhexane, 1,1-bis(4-hydroxyphenyl)decane, bis(4-hydroxy-3-nitrophenyl)methane, 3,3-bis(4-hydroxyphenyl)pentane, 1,3-bis(2-(4-hydroxyphenyl)-2-propyl)benzene, 1,3-bis(2-(4-hydroxyphenyl)-2-propyl)benzene, 2,2-bis(4-hydroxyphenyl)hexafluoro propane, 1,1-bis(4-hydroxyphenyl)cyclohexane, bis(4-hydroxyphenyl)sulfone, 2,4'-dihydroxydiphenylsulfone, bis(4-hydroxyphenyl)sulfide, bis(4-hydroxy-3-methylphenyl)sulfide, bis(4-hydroxyphenyl)disulfide, 4,4'-dihydroxydiphenyl ether, 4,4'-dihydroxy-3,3'-dichlorodiphenyl ether, and 4,4'-(propane-2,2-diyl)bis(2-allylphenol).

Also, examples of the aromatic dihydroxy compound include a dihydroxy compound having an ether group bonded to an aromatic group such as 2,2-bis(4-(2-hydroxyethoxy)phenyl)propane, 2,2-bis(4-(2-hydroxypropoxy)phenyl)propane, 1,3-bis(2-hydroxyethoxy)benzene, 4,4'-bis(2-hydroxyethoxy)biphenyl, and bis(4-(2-hydroxyethoxy)phenyl)sulfone; and a dihydroxy compound having a fluorene ring such as 9,9-bis(4-(2-hydroxyethoxy)phenyl)fluorene, 9,9-bis(4-hydroxyphenyl)fluorene, 9,9-bis(4-hydroxy-3-methylphenyl)fluorene, 9,9-bis(4-(2-hydroxypropoxy)phenyl)fluorene, 9,9-bis(4-(2-hydroxyethoxy)-3-methylphenyl)fluorene, 9,9-bis(4-(2-hydroxypropoxy)-3-methylphenyl)fluorene, 9,9-bis(4-(2-hydroxyethoxy)-3-isopropylphenyl)fluorene, 9,9-bis(4-(2-hydroxyethoxy)-3-isobutylphenyl)fluorene, 9,9-bis(4-(2-hydroxyethoxy)-3-tert-butylphenyl)fluorene, 9,9-bis(4-(2-hydroxyethoxy)-3-cyclohexylphenyl)fluorene, 9,9-bis(4-(2-hydroxyethoxy)-3-phenylphenyl)fluorene, 9,9-bis(4-(2-hydroxyethoxy)-3,5-dimethylphenyl)fluorene, 9,9-bis(4-(2-hydroxyethoxy)-3-tert-butyl-6-methylphenyl)fluorene, and 9,9-bis(4-(3-hydroxy-2,2-dimethylpropoxy)phenyl)fluorene.

From the viewpoint of improving the solubility of a curable resin, it is preferable that the curable resin further include a structural unit represented by the following formula (4) (hereinafter, also referred to as a "straight chain diol unit"): 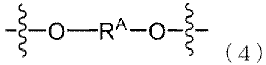 wherein R^{A} is a straight chain alkylene group.

In the formula (4), R^{A} is preferably a straight chain alkylene group having 1 to 10 carbon atoms, more preferably a straight chain alkylene group having 3 to 8 carbon atoms, and still more preferably a straight chain alkylene group having 6 carbon atoms.

Examples of the monohydroxy compound having an ethylenic double bond include a hydroxy group-containing (meth)acrylate, and specific examples thereof include 2-hydroxyethyl (meth)acrylate, 3-hydroxypropyl (meth)acrylate, 4-hydroxybutyl (meth)acrylate, trimethylolpropane di(meth)acrylate, and pentaerythritol tri(meth)acrylate.

Also, the curable resin may contain a substructure such as a structure derived from a silicone oil having a hydroxy group in a molecular structure, and a silicone oil having a carboxy group in a molecular structure.

As the silicone oil having a hydroxy group in the molecular structure, a commercially available product may be used, and examples thereof include "KF-6001" (functional group equivalent: 900) and "KF-6002" (functional group equivalent: 1600) having a hydroxy group at both ends and "X-22-1821" (functional group equivalent: 1470) having a phenolic hydroxy group at both ends (the above, manufactured by Shin-Etsu Chemical Co., Ltd.), "BY-16-752A" (functional group equivalent: 1500) having a hydroxy group at both ends (the above, manufactured by DuPont Toray Specialty Materials K.K.), "X-22-170BX" (functional group equivalent: 2800), "X-22-170DX" (functional group equivalent: 4670), "X-22-176DX" (functional group equivalent: 1600), and "X-22-176F" (functional group equivalent: 6300) having a hydroxy group at one end (the above, manufactured by Shin-Etsu Chemical Co., Ltd.), "X-22-4039" (functional group equivalent: 970) and "X-22-4015" (functional group equivalent: 1870) having a hydroxy group at a side chain (the above, manufactured by Shin-Etsu Chemical Co., Ltd.); "SF8427" (functional group equivalent: 930, manufactured by DuPont Toray Specialty Materials K.K.) and "X-22-4952" (functional group equivalent: 1100, manufactured by Shin-Etsu Chemical Co., Ltd.) having a hydroxy group in a both-end polyether; and "FZ-2162" (functional group equivalent: 750) and "SH3773M" (functional group equivalent: 800) having a hydroxy group in a side-chain polyether (the above, manufactured by DuPont Toray Specialty Materials K.K.).

As the silicone oil having a carboxy group in the molecular structure, a commercially available product may be used, and examples thereof include "X-22-162C" (functional group equivalent: 2300) having a carboxy group at both ends, "X-22-3710" (functional group equivalent: 1450) having a carboxy group at one end, and "X-22-3701E" (functional group equivalent: 4000) having a carboxy group at a side chain (the above, manufactured by Shin-Etsu Chemical Co., Ltd.).

Through introduction of the structural unit and/or substructure as described above into the curable resin of the present embodiment, properties such as flexibility, strength, heat resistance, flame retardancy, color tone, and solubility in solvent tend to be improved or imparted.

The end group in the curable resin of the present embodiment is not particularly limited and may be, for example, a carboxy group and/or hydroxy group. It is preferable that the end group have a structure with a carboxy group and/or hydroxy group capped by an end capping agent. In an aspect having an end capping agent, the curable resin tends to have more excellent dielectric properties.

The capping agent for an end carboxy group is not particularly limited, as long as it has a group reactive with the carboxy group, and examples thereof include a carbodiimide compound such as monocarbodiimide and polycarbodiimide compounds, oxazoline compounds and one-end diols.

Examples of the capping agent for an end hydroxy group include diphenyl carbonate and monocarboxylic acid.

The molar ratio of the dicarboxylic acid unit represented by formula (1) relative to the dihydroxy unit represented by formula (2) ([Dicarboxylic acid unit]/[Dihydroxy unit]) is preferably 0.01 or more and less than 1, more preferably 0.05 or more and 0.6 or less, and still more preferably 0.05 or more and 0.3 or less. With a molar ratio in the range, the flexibility of the polycarbonate backbone (cyclohexane dimethanol-diphenyl carbonate copolymer backbone) can be utilized, and sufficient crosslinking to a thermosetting resin is achieved, so that the strength is improved. The molar ratio may be measured by a nuclear magnetic resonance apparatus (NMR).

The molar ratio of the carbonate unit represented by formula (3) relative to the dihydroxy unit represented by formula (2) ([Carbonate unit]/[Dihydroxy unit]) is preferably 0.01 or more and less than 1, more preferably 0.4 or more and 0.95 or less, and still more preferably 0.7 or more and 0.95 or less. With a molar ratio in the range, the reaction proceeds favorably, and the flexibility of the polycarbonate backbone (cyclohexane dimethanol-diphenyl carbonate copolymer backbone) can be utilized. The molar ratio may be measured by a nuclear magnetic resonance apparatus (NMR).

The molar ratio of the carbonate unit represented by formula (3) relative to the dicarboxylic acid unit represented by formula (1) ([Carbonate unit]/[Dicarboxylic acid unit]) is preferably 1 or more and 100 or less, more preferably 2 or more and 50 or less, and still more preferably 2 or more and 30 or less. With a molar ratio in the range, the flexibility of the polycarbonate backbone (cyclohexane dimethanol-diphenyl carbonate copolymer backbone) can be utilized, and sufficient crosslinking to a thermosetting resin is achieved, so that the strength is improved. The molar ratio may be measured by a nuclear magnetic resonance apparatus (NMR).

The molar ratio of the total of the dicarboxylic acid unit, the dihydroxy unit and the carbonate unit relative to all the structural units constituting a curable resin ([Dicarboxylic acid unit + Dihydroxy unit + Carbonate unit]/[All structural units]) is preferably 0.6 or more, more preferably 0.7 or more, and still more preferably 0.8 or more and preferably 0.9 or more. The upper limit of the molar ratio may be, for example, 1, 0.98 or 0.96, though not particularly limited. The molar ratio may be measured by a nuclear magnetic resonance apparatus (NMR).

The molar ratio of the straight chain diol unit represented by formula (4) relative to the dihydroxy unit represented by formula (2) ([Straight chain diol unit]/[Dihydroxy unit]) is preferably 0.01 or more and 0.99 or less, more preferably 0.05 or more and 0.8 or less, and still more preferably 0.1 or more and 0.6 or less.

From the viewpoint of further improving the solubility of the curable resin in solvent, the bleed-out resistance, etc., the proportion of the structural unit represented by the formula (1) in all the structural units derived from the dicarboxylic acid compound in the curable resin is preferably 0.60 or more, more preferably 0.70 or more, still more preferably 0.80 or more, and furthermore preferably 0.90 or more. The upper limit of the proportion may be, for example, 1.0, 0.98 or 0.96, though not particularly limited.

From the same viewpoint, the proportion of the structural unit represented by the formula (2) in all the structural units derived from the dihydroxy compound in the curable resin is preferably 0.10 or more, more preferably 0.20 or more, still more preferably 0.30 or more, and furthermore preferably 0.50 or more. The upper limit of the proportion may be, for example, 1.0, 0.98 or 0.96, though not particularly limited.

The proportion of the structural unit represented by the formula (1) and the proportion of the structural unit represented by the formula (2) may be measured by a nuclear magnetic resonance apparatus (NMR).

The content of the structural unit derived from each monomer may be controlled through adjustment of the amount charged (amount used) of each monomer in production of the curable resin. On this occasion, it is preferable that a greater amount of a monomer that easily evaporates to flow out of the system be used in comparison with a monomer that is unlikely to evaporate, in consideration of the flow out from the system.

The number average molecular weight of the curable resin of the present invention is preferably 5.00×10² or more and 3.00×10⁴ or less, more preferably 1.00×10³ or more and 2.00×10⁴ or less, and still more preferably 3.00×10³ or more and 1.00×10⁴ or less. With a number average molecular weight of 3.00×10⁴ or less, the solubility in solvent for the curable resin tends to be further improved. Accordingly, in an aspect with a number average molecular weight of 3.00×10⁴ or less, the curable resin is suitably used for impregnation into filler (for example, glass cloth) of a copper clad laminate or the like, or for dissolving in a solvent such as an unsaturated polyester. Further, in the case where the curable resin has a number average molecular weight of 3.00×10⁴ or less, when mixed with another curable resin such as a maleimide resin and cured, occurrence of bleed out (a phenomenon in which no homogeneous reaction of the resin occurs with visible aggregation of a same composition) tends to be surely prevented.

On the other hand, with a number average molecular weight of 5.00×10² or more, the polycarbonate backbones are incorporated sufficiently into the resin, so that the strength tends to be further improved. The number average molecular weight may be measured by gel permeation chromatography (GPC).

The glass transition temperature (Tg) of the curable resin is preferably 60°C or less, more preferably 50°C or less, and still more preferably 45°C or less. With a Tg in the range, the curable resin is capable of having a further high strength. Tg may be measured by the method described in Example.

### <Method for producing curable resin>

An embodiment of the present invention relates to a method for producing a curable resin including the step of reacting (hereinafter, referred to as "reaction step"):
a dicarboxylic acid compound represented by the following formula (1A) or an acid anhydride thereof: 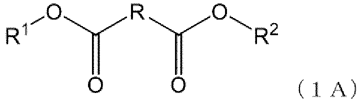
wherein R is a divalent group having an ethylenic double bond and/or an acetylenic triple bond, and R¹ and R² are each independently a hydrogen atom or an alkyl group;
a dihydroxy compound represented by the following formula (2A): 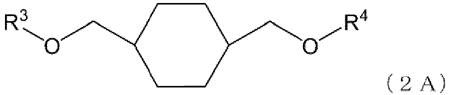
wherein R³ and R⁴ are each independently a hydrogen atom or an alkyl group; and
a carbonate compound represented by the following formula (3A): 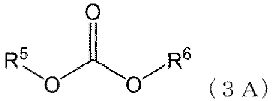
wherein R⁵ and R⁶ are each independently an alkyl group or an aryl group.

The dicarboxylic acid unit represented by the formula (1) is derived from a dicarboxylic acid compound represented by the formula (1A) or an acid anhydride thereof.

The dihydroxy unit represented by the formula (2) is derived from a dihydroxy compound represented by the formula (2A).

The carbonate unit represented by the formula (3) is derived from a carbonate compound represented by the formula (3A).

In the formula (1A), a preferred aspect of R is as described relating to R in the formula (1) in the section <Curable resin>. Though not particularly limited, the dicarboxylic acid compound is preferably fumaric acid or maleic acid, and the acid anhydride of dicarboxylic acid compound is preferably maleic anhydride.

In (1A), R¹ and R² are each independently a hydrogen atom or an alkyl group, preferably a hydrogen atom or an alkyl group having 1 to 7 carbon atoms, more preferably a hydrogen atom or an alkyl group having 1 to 3 carbon atoms, and still more preferably a hydrogen atom.

In (2A), R³ and R⁴ are each independently a hydrogen atom or an alkyl group, preferably a hydrogen atom or an alkyl group having 1 to 7 carbon atoms, more preferably a hydrogen atom or an alkyl group having 1 to 3 carbon atoms, and still more preferably a hydrogen atom.

In (3A), R⁵ and R⁶ are each independently an alkyl group or an aryl group, preferably an alkyl group having 1 to 6 carbon atoms or an aryl group having 6 to 12 carbon atoms, more preferably an alkyl group having 1 to 3 carbon atoms or an aryl group (phenyl group) having 6 carbon atoms, and still more preferably a phenyl group.

The carbonate compound is not particularly limited, and examples of thereof include diphenyl carbonate, ditolyl carbonate, dimethyl carbonate, diethyl carbonate, di-t-butyl carbonate, bis(chlorophenyl)carbonate, m-cresyl carbonate, and dichlorohexyl carbonate. The carbonate compound is preferably diphenyl carbonate and/or an alkyl group-substituted diphenyl carbonate.

The dicarboxylic acid compound, dicarboxylic acid anhydride, dihydroxy compound and carbonate compound may be used alone or may be used in combination of two or more.

In the method for producing curable resin of the present embodiment, a monomer, an oligomer or a polymer other than the dicarboxylic acid compound represented by the formula (1A) or the acid anhydride thereof, the dihydroxy compound represented by the formula (2A), and the carbonate compound represented by the formula (3A) may be added to a reaction system so as to be incorporated into a curable resin. Examples of such a compound include a dicarboxylic acid compound other than the dicarboxylic acid compound represented by the formula (1A) and an acid anhydride thereof, a dihydroxy compound other than the dihydroxy compound represented by the formula (2A), a monohydroxy compound having an ethylenic double bond, a silicone oil having a hydroxy group in the molecular structure, and a silicone oil having a carboxy group in the molecular structure. Examples of these compounds include ones described in detail in the explanation of the curable resin in the present embodiment, which may be used alone or may be used in combination of two or more.

In the reaction step described above, a straight chain diol represented by the following formula (4A) may be further reacted:

HO-R^{A}-OH (4A)

wherein R^{A} is a straight chain alkylene group.

In the formula (4A), R^{A} is preferably a straight chain alkylene group having 1 to 10 carbon atoms, more preferably a straight chain alkylene group having 3 to 8 carbon atoms, and still more preferably a straight chain alkylene group having 6 carbon atoms.

In the reaction step, the amounts used (molar ratios) of the dicarboxylic acid compound or an acid anhydride thereof, the dihydroxy compound, the carbonate compound, and the straight chain diol compound are as explained in the relations of [Dicarboxylic acid unit]/[Dihydroxy unit], [Carbonate unit]/[Dihydroxy unit], [Carbonate unit]/[Dicarboxylic acid unit] and [Straight chain diol unit]/[Dihydroxy unit] described in the section of the <Curable resin>. Incidentally, regarding the amount used of each compound, the amount used of a compound that more easily evaporates may be increased with reference to the easiness of evaporation of each compound (for example, the saturation vapor pressure at the reaction temperature) as an index.

In the method for producing the curable resin of the present embodiment, the proportion of the total amount used of the dicarboxylic acid compound, dicarboxylic anhydride, dihydroxy compound and carbonate compound in the total amount of the compounds for use, represented by molar ratio, is preferably 0.60 or more, more preferably 0.70 or more, still more preferably 0.80 or more, and furthermore preferably 0.90 or more. The upper limit of the proportion may be, for example, 1.0, 0.98, or 0.96, though not particularly limited. With a proportion of 0.60 or more, a curable resin further excellent in the solubility in solvent, bleed-out resistance, etc. tends to be produced.

From the viewpoint of producing a curable resin further excellent in the solubility in solvent, bleed-out resistance, etc., the proportion of the amount of used of the dicarboxylic acid compound represented by the formula (1A) and an anhydride thereof in all of the compounds having 2 carboxylic groups and anhydrides thereof for use in the production method of the present embodiment is preferably 0.60 or more, more preferably 0.70 or more, still more preferably 0.80 or more, and furthermore preferably 0.90 or more. The upper limit of the proportion may be, for example, 1.0, 0.98 or 0.96, though not particularly limited.

From the same viewpoint, the proportion of the amount used of the dihydroxy compound represented by the formula (2A) in all the compounds having 2 hydroxy groups for use in the production method of the present embodiment is preferably 0.10 or more, more preferably 0.20 or more, still more preferably 0.30 or more, and furthermore preferably 0.50 or more. The upper limit of the proportion may be, for example, 1.0, 0.98 or 0.96, though not particularly limited.

In the reaction step, it is preferable to react the dihydroxy compound and the carbonate compound (hereinafter referred to as "first reaction"), and then to react with the dicarboxylic acid compound or an acid anhydride thereof (hereinafter referred to as "second reaction").

The temperature for the first reaction is preferably 100 to 290°C, more preferably 130 to 280°C, and still more preferably 160 to 260°C.

The pressure for the first reaction is preferably 50 kPa or less, more preferably 10 kPa or less, and still more preferably 1 kPa or less.

It is preferable that the first reaction be performed in the presence of an inert gas. Examples of the inert gas include nitrogen gas and argon gas.

It is preferable that the first reaction be performed in the presence of a catalyst. Examples of the catalyst include a catalyst usually used for synthesis of a polycarbonate or polyester. Specific examples thereof include an alkali metal compound, an alkaline earth metal compound, a nitrogen-containing compound, and a salt of titanium, tin, zinc, zirconium and/or lead. It is also possible to use a basic compound such as a basic boron compound and a basic phosphorus compound supplementarily together with the alkali metal compound and/or the alkaline earth metal compound.

Examples of the alkali metal compound include an organic acid salt, an inorganic salt, an oxide, a hydroxide, a hydride and an alkoxide of an alkali metal. Specific examples thereof include sodium hydroxide, potassium hydroxide, lithium hydroxide, cesium hydroxide, sodium hydrogen carbonate, potassium hydrogen carbonate, lithium hydrogen carbonate, cesium hydrogen carbonate, sodium carbonate, potassium carbonate, lithium carbonate, cesium carbonate, sodium acetate, potassium acetate, lithium acetate, cesium acetate, sodium stearate, potassium stearate, lithium stearate, cesium stearate, sodium borohydride, potassium borohydride, lithium borohydride, cesium borohydride, sodium phenyl borate, potassium phenyl borate, lithium phenyl borate, cesium phenyl borate, sodium benzoate, potassium benzoate, lithium benzoate, cesium benzoate, disodium hydrogen phosphate, dipotassium hydrogen phosphate, dilithium hydrogen phosphate, dicesium hydrogen phosphate, disodium phenyl phosphate, dipotassium phenyl phosphate, dilithium phenyl phosphate, dicesium phenyl phosphate, an alcoholate and phenolate of sodium, potassium, lithium or cesium, and a sodium salt, a dipotassium salt, a dilithium salt and a dicesium salt of bisphenol A.

Examples of the alkaline earth metal compound include an organic acid salt, inorganic salt, oxide, hydroxide, hydride and alkoxide of an alkaline earth metal compound. Specific examples thereof include calcium hydroxide, barium hydroxide, magnesium hydroxide, strontium hydroxide, calcium hydrogen carbonate, barium hydrogen carbonate, magnesium hydrogen carbonate, strontium hydrogen carbonate, calcium carbonate, barium carbonate, magnesium carbonate, strontium carbonate, calcium acetate, barium acetate, magnesium acetate, strontium acetate, calcium stearate, barium stearate, magnesium stearate and strontium stearate.

Examples of the nitrogen-containing compound include a quaternary ammonium hydroxide and a salt thereof, and amines. Specific examples thereof include a quaternary ammonium hydroxide having an alkyl group and/or aryl group such as tetramethylammonium hydroxide, tetraethylammonium hydroxide, tetrapropylammonium hydroxide, tetrabutylammonium hydroxide, and trimethyl benzylammonium hydroxide; a tertiary amine such as triethyl amine, dimethyl benzyl amine, and triphenyl amine; a secondary amine such as diethyl amine and dibutyl amine; a primary amine such as propyl amine and butyl amine; imidazoles such as 2-methyl imidazole, 2-phenyl imidazole, and benzoimidazole; and a base or a basic salt such as ammonia, tetramethylammonium borohydride, tetrabutylammonium borohydride, tetrabutylammonium tetraphenylborate, and tetraphenylammonium tetraphenylborate.

Examples of the titanium salt include tetramethyl titanate, tetrabutyl titanate, tetrapropyl titanate, tetraisopropyl titanate, tetraisobutyl titanate, and tetraphenyl titanate.

Examples of the tin salt include tin (II) chloride, tin (IV) chloride, tin (II) acetate, tin (IV) acetate, dibutyltin oxide, dibutyltin dilaurate, dibutyltin dimethoxide, and dibutyltin diacetate.

Example of the zinc salt include zinc acetate, zinc benzoate, and zinc 2-ethyl hexanoate.

Examples of the zirconium salt include zirconium acetylacetonate, zirconium oxyacetate, and zirconium tetrabutoxide.

Examples of the lead salt include lead (II) acetate and lead (IV) acetate.

Examples of the basic boron compound for use in combination with an alkali metal compound and/or alkaline earth metal compound include a sodium salt, potassium salt, lithium salt, calcium salt, barium salt, magnesium salt and strontium salt of tetramethyl boron, tetraethyl boron, tetrapropyl boron, tetrabutyl boron, trimethyl ethyl boron, trimethyl benzyl boron, trimethyl phenyl boron, triethyl methyl boron, triethyl benzyl boron, triethyl phenyl boron, tributyl benzyl boron, tributyl phenyl boron, tetraphenyl boron, benzyl triphenyl boron, methyl triphenyl boron, and butyl triphenyl boron.

Examples of the basic phosphorus compound include triethylphosphine, tri-n-propylphosphine, tri-isopropylphosphine, tri-n-butylphosphine, triphenylphosphine, tributylphosphine, and a quaternary phosphonium salt.

Examples of the catalyst that is usually used for synthesis of a polycarbonate and polyester include an antimony compound such as diantimony trioxide; a germanium compound such as germanium dioxide and germanium tetroxide; a manganese compound and catalysts disclosed in US Patents No. 4025492, No. 4136089, No. 4176224, No. 4238593 and No. 4208527, and R. E. Wilfong, Journal of Polymer Science, 54, 385, (1961).

The temperature for the second reaction is preferably 80 to 290°C, more preferably 120 to 270°C, and still more preferably 150 to 250°C.

The pressure for the second reaction is preferably 100 kPa or less, more preferably 50 kPa or less, and still more preferably 30 kPa or less.

It is preferable that the second reaction be performed in the presence of an inert gas. Examples of the inert gas include nitrogen gas and argon gas.

It is preferable that the second reaction be performed in the presence of a catalyst. Examples of the catalyst include ones exemplified as the catalyst for the first reaction. It is preferable that the catalyst used for the first reaction be used as it is for the second reaction. Alternatively, the catalyst may be added for the second time.

Regarding the production method of the present embodiment, "Polyester Resin Handbook" (by Eiichiro Takiyama, published by THE NIKKAN KOGYO SHIMBUN, LTD.) may be appropriately referenced to.

In addition to the production method described above, the curable resin of the present embodiment may be produced by a method of reacting a polycarbonate diol with at least one of a dicarboxylic acid compound and a dicarboxylic acid anhydride. The polycarbonate diol for use is not particularly limited as long as it is a compound that includes a carbonate bond and has a hydroxy group at both ends, and examples thereof include a conventionally known and commercially available polycarbonate diol. The reaction conditions and usable catalysts may be the same as ones for the second reaction described above.

Further, in the production method including the first reaction and the second reaction, a polycarbonate diol may be used instead of the dihydroxy compound represented by the formula (2A). The polycarbonate diol for use is not particularly limited as long as it is a compound that contains a carbonate bond and has a hydroxy group at both ends, and examples thereof include a conventionally known and commercially available polycarbonate diol. In such an aspect, a curable resin that contains many carbonate units tends to be obtained.

### <Resin composition>

One embodiment of the present invention relates to a resin composition that contains the curable resin described above. The resin composition of the present embodiment may further contain another component.

Examples of the other components that may be contained in the resin composition of the present embodiment include an epoxy resin, a cyanate compound, a maleimide compound, a BT resin, a compound having a polymerizable unsaturated group, a compound having an ester structure derived from a phenol group and an aromatic carboxylic group, a modified silicone oil, a heat stabilizer, an antioxidant, a curing agent and curing accelerator. The components may be used alone or may be used in combination of two or more.

Examples of the epoxy resin include a phenol phenyl aralkyl novolac-type epoxy resin, a phenol biphenyl aralkyl-type epoxy resin, a naphthol aralkyl-type epoxy resin, an anthraquinone-type epoxy resin, a polyoxynaphthylene-type epoxy resin, a bisphenol A-type epoxy resin, a bisphenol F-type epoxy resin, a phenol novolac-type epoxy resin, a cresol novolac-type epoxy resin, a bisphenol A novolac-type epoxy resin, a trifunctional phenol-type epoxy resin, a tetrafunctional phenol-type epoxy resin, a naphthalene-type epoxy resin, a biphenyl-type epoxy resin, an aralkyl novolac-type epoxy resin, an alicyclic epoxy resin, a polyol-type epoxy resin, a compound having an epoxidized double bond of glycidyl amine, glycidyl ester or butadiene, a compound obtained from a reaction between hydroxy group-containing silicone resins and epichlorohydrin, and a halide thereof. These may be used alone or may be used in combination of two or more.

Examples of the cyanate compound include a naphthol aralkyl-type cyanate compound, a novolac-type cyanate, a phenol biphenyl aralkyl-type cyanate compound, bis(3,5-dimethyl-4-cyanatephenyl)methane, bis(4-cyanatephenyl)methane, 1,3-dicyanatebenzene, 1,4-dicyanatebenzene, 1,3,5-tricyanatebenzene, 1,3-dicyanatenaphthalene, 1,4-dicyanatenaphthalene, 1,6-dicyanatenaphthalene, 1,8-dicyanatenaphthalene, 2,6-dicyanatenaphthalene, 2,7-dicyanatenaphthalene, 1,3,6-tricyanatenaphthalene, 4,4'-dicyanatebiphenyl, bis(4-cyanatephenyl)ether, bis(4-cyanatephenyl)thioether, bis(4-cyanatephenyl)sulfone, 2,2-bis(4-cyanatephenyl)propane, polymethylene polyphenyl polyisocyanate, m-tetramethylxylene diisocyanate, hydrogenated xylene diisocyanate(1,3-bis(isocyanatemethyl)cyclohexane), isophorone diisocyanate, norbornene diisocyanate, dicyclohexylmethane diisocyanate, hydrogenated methylene bisphenylene diisocyanate, 1,4-cyclohexane diisocyanate, 1,6-hexamethylene diisocyanate, trimethylene diisocyanate, and a trifunctional isocyanate having an isocyanurate ring with a trimerized difunctional isocyanate compound. These may be used singly, or may be used in combinations of two or more thereof.

Examples of the maleimide compound include N-phenyl maleimide, N-hydroxyphenyl maleimide, bis(4-maleimidephenyl)methane, 2,2-bis{4-(4-maleimidephenoxy)-phenyl}propane, bis(3,5-dimethyl-4-maleimidephenyl)methane, bis(3-ethyl-5-methyl-4-maleimidephenyl)methane, bis(3,5-diethyl-4-maleimidephenyl)methane, a prepolymer of these maleimide compounds, and a prepolymer of a maleimide compound and an amine compound. These may be used singly, or may be used in combinations of two or more thereof.

The BT resin is a prepolymer made by heating and mixing a cyanate compound and a maleimide compound without solvent or after dissolving the same in an organic solvent such as methyl ethyl ketone, N-methylpyrrolidone, dimethyl formaldehyde, dimethyl acetoamide, toluene and xylene. As the cyanate compound and the maleimide compound, those described above may be used. These may be used singly, or may be used in combinations of two or more thereof.

The compound having a polymerizable unsaturated group is not particularly limited, and examples thereof include a vinyl compound such as ethylene, styrene, divinylbenzene and divinyl biphenyl; (meth)acrylates of monohydric or polyhydric alcohol such as methyl (meth)acrylate, 2-hydroxyethyl (meth)acrylate, 2-hydroxypropyl (meth)acrylate, tricyclodecanol (meth)acrylate, tricyclodecanol di(meth)acrylate, tricyclodecanol tri(meth)acrylate, polypropylene glycol di(meth)acrylate, trimethylolpropane di(meth)acrylate, trimethylolpropane tri(meth)acrylate, pentaerythritol tetra(meth)acrylate, and dipentaerythritol hexa(meth)acrylate; epoxy(meth)acrylates such as bisphenol A-type epoxy(meth)acrylate and bisphenol F-type epoxy(meth)acrylate; an allyl compound such as allylchloride, allyl acetate, allyl ether, propylene, triallyl cyanurate, triallyl isocyanurate, diallyl phthalate, diallyl isophthalate, and diallyl maleate; a benzo cyclobutene resin; and a (bis)maleimide resin. These compounds having a polymerizable unsaturated group may be used alone or as a mixture of two or more.

Examples of the compound having an ester structure derived from a phenol group and an aromatic carboxylic group include an active ester resin (I) of which reaction starting material is a compound selected from a compound (a1) having one phenolic hydroxy group, a compound (a2) having two or more phenolic hydroxy groups, and an aromatic polycarboxylic acid or acid halide thereof (a3), and an active ester resin (II) of which reaction starting material is a compound selected from a compound (b1) having two or more phenolic hydroxy groups, an aromatic monocarboxylic acid or acid halide thereof (b2), and an aromatic polycarboxylic acid or an acid halide thereof (b3). Specific examples of these compounds may be referred to International Publication No. WO 2020/003824. These may be used singly, or may be used in combinations of two or more thereof.

Examples of the modified silicone oil include ones having a chain siloxane backbone, with a group other than hydrogen or a hydrocarbon group in the molecular structure. Examples of the modified group include an epoxy group, an amino group, a hydroxy group, a methacrylic group, a mercapto group, a carboxy group, an alkoxy group and a silanol group. These may be used singly, or may be used in combinations of two or more thereof.

Examples of the heat stabilizer include phosphorus acid, phosphoric acid, phosphonous acid, phosphonic acid, and an ester thereof. Specific examples thereof include triphenyl phosphite, tris(nonylphenyl)phosphite, tris(2,4-di-tert-butylphenyl)phosphite, tridecyl phosphite, trioctyl phosphite, trioctadecyl phosphite, didecyl monophenyl phosphite, dioctyl monophenyl phosphite, diisopropyl monophenyl phosphite, monobutyl diphenyl phosphite, monodecyl diphenyl phosphite, monooctyl diphenyl phosphite, bis(2,6-di-tert-butyl-4-methylphenyl)pentaerythritol diphosphite, 2,2-methylene bis(4,6-di-tert-butylphenyl)octyl phosphite, bis(nonylphenyl)pentaerythritol diphosphite, bis(2,4-di-tert-butylphenyl)pentaerythritol diphosphite, distearyl pentaerythritol diphosphite, tributyl phosphate, triethyl phosphate, trimethyl phosphate, triphenyl phosphate, diphenyl monoorthoxenyl phosphate, dibutyl phosphate, dioctyl phosphate, diisopropyl phosphate, 4,4'-biphenylene diphosphinic acid tetrakis(2,4-di-tert-butylphenyl), dimethyl benzene phosphonate, diethyl benzene phosphonate, and dipropyl benzene phosphonate. These may be used singly, or may be used in combinations of two or more thereof.

Examples of the antioxidant include pentaerythritol tetrakis(3-mercaptopropionate), pentaerythritol tetrakis(3-laurylpropionate), glycerol-3-stearyl thiopropionate, triethylene glycerol-bis[3-(3-tert-butyl-5-methyl-4-hydroxyphenyl)propionate], 1,6-hexanediol-bis[3-(3,5-di-tert-butyl-4-hydroxyphenyl)propionate], pentaerythritol-tetrakis[3-(3,5-di-tert-butyl-4-hydroxyphenyl)propionate], octadecyl-3-(3,5-di-tert-butyl-4-hydroxyphenyl)propionate, 1,3,5-trimethyl-2,4,6-tris(3,5-di-tert-butyl-4-hydroxybenzyl)benzene, N,N-hexamethylene bis(3,5-di-tert-butyl-4-hydroxyhydrocinnamide), 3,5-di-tert-butyl-4-hydroxy-benzylphosphate-diethyl ester, tris(3,5-di-tert-butyl-4-hydroxybenzyl)isocyanurate, 4,4'-biphenylene diphosphonic acid tetrakis(2,4-di-tert-butylphenyl), and 3,9-bis{1,1-dimethyl-2-[β-(3-tert-butyl-4-hydroxy-5-methylphenyl)propionyloxy]ethyl}-2,4,8,10-tetraoxaspiro(5,5)undecane. These may be used singly, or may be used in combinations of two or more thereof.

Examples of the curing agent include a polyfunctional phenolic compound such as phenol novolac, cresol novolac and aminotriazine novolac resins; an amine compound such as dicyandiamide, diaminodiphenylmethane and diaminodiphenylsulfone; and an acid anhydride such as phthalic anhydride, pyromelltic anhydride and maleic anhydride.

Examples of the curing accelerator include an organic metal salt and organic metal complex such as zinc naphthenate, cobalt naphthenate, tin octylate, cobalt octylate, bisacetylacetonate cobalt (II), trisacetylacetonate cobalt (III), zinc (II) acetylacetonate and iron (III) acetylacetonate, imidazoles and derivatives thereof, organic phosphorus compounds, secondary amines, tertiary amines and quaternary ammonium salts.

These may be used singly, or may be used in combinations of two or more thereof.

It is preferable that the resin composition of the present embodiment contain a component that reacts with the curable resin of the present embodiment to be cured together, among the components described above. Examples of such a component include (meth)acrylate, isocyanurate, a maleimide compound, a compound having a vinyl group, and a compound having an allyl group.

The resin composition of may further contain an initiator for initiating curing. Examples of the initiator include an organic peroxide-based initiator that initiates curing by heating, and a UV initiator that initiates curing by exposure to light.

Examples of the organic peroxide-based initiator include a ketone peroxide such as methyl ethyl ketone peroxide and acetyl acetone peroxide; a diacyl peroxide such as benzoyl peroxide; a peroxy ester such as t-butylperoxybenzoate; a hydroperoxide such as cumene hydroperoxide; and a dialkyl peroxide such as dicumyl peroxide.

Examples of the UV initiator include a benzophenone such as benzophenone, benzyl and methyl orthobenzoyl benzoate; a benzoin ether such as benzoin alkyl ether; an acetophenone such as benzyl dimethyl ketal, 2,2-diethoxy acetophenone, 2-hydroxy-2-methylpropyl phenone, 4-isopropyl-2-hydroxy-2-methylpropiophenone, and 1,1-dichloroaceto phenone; and thioxanthone such as 2-chlorothioxanthone, 2-methylthioxanthone, and 2-isopropylthioxanthone.

The resin composition may further contain a crosslinking agent. Alternatively, the curable resin of the present embodiment may be cured alone without use of a crosslinking agent, due to having an ethylenic double bond and/or an acetylenic triple bond. Accordingly, the resin composition of the present embodiment may contain no crosslinking agent.

The content of the curable resin of the present embodiment in the resin composition may be, for example, 1.0 part by mass or more relative to 100 parts by mass of resin component (resin and component to be cured together with the resin, i.e. a synonym for solid component).

For example, in the case where the curable resin of the present embodiment as compatibilizer is added to a resin composition, the content of the curable resin of the present embodiment may be, for example, 1.0 part by mass or more and 10 parts by mass or less, or 3.0 parts by mass or more and 5.0 parts by mass or less, relative to 100 parts by mass of the resin component.

Alternatively, the content of the curable resin of the present embodiment in the resin composition may be, for example, 10 parts by mass or more, 20 parts by mass or more, 30 parts by mass or more, 50 parts by mass or more, 70 parts by mass or more, 80 parts by mass or more, 90 parts by mass or more, or 95 parts by mass or more, relative to 100 parts by mass of the resin component. With a content of the curable resin of the present embodiment in the range, a resin composition furthermore excellent in dielectric properties tends to be obtained. Also, a cured product of the resin composition tends to have good color tone with a low degree of yellowness. Further, adhesion to metal tends to be improved.

The upper limit of the content of the curable resin of the present embodiment in the resin composition is not particularly limited, and may be 100 parts by mass, 99 parts by mass, 95 parts by mass, 90 parts by mass, or 80 parts by mass, relative to 100 parts by mass of the resin component.

Incidentally, the content of the components other than the curable resin of the present embodiment in the resin composition may be appropriately adjusted in the range where the content of the curable resin of the present embodiment is in the range described above.

The resin composition may further contain a filler such as reinforcing base material and inorganic filler.

The inorganic filler is not particularly limited as long as it is usually used in the industry. Specific examples include silicas such as natural silica, fused silica, amorphous silica and hollow silica; metal hydroxides such as aluminum hydroxide, heat-treated products of aluminum hydroxide (ones produced by heat-treating aluminum hydroxide and then decreasing a part of crystalline water), magnesium hydroxide and boehmite; nitrides such as aluminum nitride and boron nitride; molybdenum compounds such as molybdenum oxide and zinc molybdate; zinc borate, zinc stannate, alumina, clay, kaolin, talc, fired clay, fired kaolin, fired talc, mica, short glass fiber (fine glass particles such as E-glass or D-glass), hollow glass, spherical glass, titanium oxide, silicone rubber, and silicone composite powder.

Examples of the reinforcing base material include paper, glass cloth, nonwoven glass cloth, aramid paper, glass mat and glass roving cloth.

The fillers may be used singly, or may be used in combinations of two or more thereof.

The content of filler in the resin composition is, for example, 1 to 2000 parts by mass relative to 100 parts by mass of the resin component, though not particularly limited. The content of filler may be appropriately changed depending on the use of the resin composition.

The resin composition may contain a silane coupling agent and a wetting and dispersing agent in addition to a filler. These components contained therein improves dispersibility of the filler, particularly the inorganic filler, and tends to improve the adhesive strength between the resin and the filler.

The silane coupling agent is not particularly limited, as long as it is a silane coupling agent for general use in surface treatment of inorganic products. Specific examples include an aminosilane-based silane coupling agent such as γ-aminopropyl triethoxysilane and N-β-(aminoethyl)-γ-aminopropyl trimethoxysilane; an epoxysilane-based silane coupling agent such as γ-glycidoxypropyl trimethoxysilane; a vinylsilane-based silane coupling agent such as γ-methacryloxy propyltrimethoxysilane; a cationic silane-based silane coupling agent such as N-β-(N-vinylbenzylaminoethyl)-y-aminopropyl trimethoxysilane hydrochloride; a phenyl silane-based silane coupling agent; and a styryl silane-based coupling agent such as p-styryl trimethoxysilane, p-styryl triethoxysilane, p-styryl methyldimethoxysilane, p-styryl methyldiethoxysilane, and N-(vinylbenzyl)-2-aminoethyl-3-aminopropyl trimethoxysilane hydrochloride.

The wetting and dispersing agent is not particularly limited, as long as it is a dispersion stabilizer for use in paints. Specific examples thereof include a wetting and dispersing agent such as Disperbyk-110, 111, 180, 161, BYK-W996, W9010 and W903 manufactured by BYK Japan KK.

These silane coupling agents and wetting and dispersing agents may be used alone or may be used in a combination of two or more.

The resin composition of the present embodiment may further contain a solvent on an as needed basis. By containing an organic solvent, the resin composition has a lowered viscosity during preparation, so that handling properties tend to be improved. The solvent is not particularly limited, as long as it can dissolve at least one component in the resin composition. Specific examples thereof include ketones such as acetone, methyl ethyl ketone, and methyl cellosolve; aromatic hydrocarbons such as toluene and xylene; amides such as dimethyl formamide; propylene glycol methyl ether and other acetates. The solvents may be used singly, or may be used in combinations of two or more thereof.

### <Cured product>

An embodiment of the present invention relates to a cured product of the curable resin described above, or a cured product of the resin composition described above. The cured product has a high strength (for example, bending strength, tensile strength or impact strength). Also, the cured product is preferably excellent in adhesion to metals. Furthermore, the cured product has a low thermal expansion coefficient.

The method for curing the curable resin or the resin composition is not particularly limited, and may be appropriately selected depending on the type of resin. Examples of the curing method include thermal curing and photocuring.

### <Use>

Examples of the use of the present embodiment include use for electronic materials, and specific examples thereof include an electronic component, a semiconductor sealing material, a mold resin, a rigid substrate, a prepreg, a laminate, a resin-attached copper foil, a circuit board, an underfill material, and a buildup film. In addition, the resin composition or cured product together with an additive such as an unsaturated polyester and an epoxy resin or the resin composition or cured product alone may be used as a fiber-reinforced composite material such as carbon fiber reinforced plastic and glass fiber reinforced plastic.

A fiber-reinforced composite material including the resin composition of the present embodiment and a reinforcement fiber may be cured to produce a fiber-reinforced formed article. The reinforcement fiber is not particularly limited, and examples thereof include a glass fiber, a carbon fiber, a boron fiber and an aramid fiber.

A semiconductor sealing material including the resin composition of the present embodiment and an inorganic filler is used for producing a semiconductor device. As the inorganic filler, ones described above may be used.

A prepreg includes a base material and the resin composition impregnated into or applied to the base material. The method for producing a prepreg is not particularly limited, and may be performed according to the usual procedure. For example, the resin composition is impregnated into or applied to a base material and then heated in a dryer at 100 to 200°C for 1 to 30 minutes, so that semi-curing (making B-stage resin) is achieved to make a prepreg.

The base material is not particularly limited, and a known one used in various printed wiring board materials may be appropriately selected depending on the application and performance for use. Specific examples of the fiber to constitute a base material is not particularly limited, and include, for example, glass fiber such as E-glass, D-glass, S-glass, Q-glass, spherical glass, NE-glass, L-glass and T-glass; inorganic fiber of other than glass such as quartz; a wholly aromatic polyamide such as polyparaphenylene terephthalamide (Kevlar (registered trademark), manufactured by DuPont de Nemours, Inc.) and copolyprarphenylene-3,4'-oxydiphenylene-terephthalamide (Technora (registered trademark), manufactured by TEIJIN LIMITED); a polyester such as 2,6-hydroxy naphthoic acid-parahydroxybenzoic acid (Vectran (registered trademark), manufactured by Kuraray Co., Ltd.) and Zxion (registered trademark, manufactured by KB SEIREN LTD.); and organic fiber such as polyparaphenylene benzoxazole (Zylon (registered trademark), manufactured by TOYOBO MC Corporation) and polyimide. These base materials may be used alone or may be used in a combination of two or more.

The laminate is a laminated body including at least a prepreg. The laminate is obtained, for example, by laminating a prepreg in combination with another layer. Examples of the other layer is not particularly limited, and examples thereof include a separately prepared wiring board for an inner layer.

The circuit board includes a laminate and a metal foil disposed on one or both surfaces of the laminate. The circuit board is, for example, a copper foil-clad laminate obtained by laminating the prepreg and a copper foil and curing the laminate. The copper foil for use is not particularly limited as long as it is used for a circuit board, and a publicly known copper foil such as a rolled copper foil and an electrolytic copper foil is preferred.

The buildup film includes a cured product of the resin composition and a base material film. The term "buildup" means preparing a printed wiring board having a multilayer structure by laminating prepregs or resin sheets and repeating drilling and wiring layer by layer.

As further effects of the present embodiment, for example, low thermal expansion, crack prevention, good color tone, solubility in solvent and suppression of separation between resins during curing are expected.

### Examples

The present invention will be described more detail with reference to Examples and Comparative Examples, though the technical scope of the present invention is not limited thereto.

### <Measurement method>

### [Glass transition point]

With use of DSC/TA-50WS manufactured by SHIMADZU CORPORATION, about 10 mg of a sample was placed in a sealed container of aluminum, and subjected to measurement in a nitrogen gas flow (30 ml/min) at a heating rate of 20°C/min. On this occasion, the temperature at the middle point in the region having a discontinuous portion in the base line (spot where specific heat is halved) was defined as glass transition temperature (Tg).

### [Bending strength]

With use of Autograph (AG-Xplus, manufactured by SHIMADZU CORPORATION), the bending strength was measured at a rate of 1 mm/min, with a support distance of 4 cm.

### [Copper foil peeling strength]

Slits were cut at an interval of 10 mm on a copper foil, and the copper foil was peeled off. When the peeled copper foil was continuously pulled to a length of about 10 cm in the direction of 180°, the maximum value of the tensile strength was defined as copper foil peeling strength. The measurement of the strength was performed at a velocity of 5 cm/min using Strograph EII-L (manufactured by Toyo Seiki Seisaku-sho Ltd.).

### [Measurement of thermal expansion coefficient]

By using a thermomechanical analyzer "TMA 7100C" manufactured by Hitachi High-Tech Corporation, a sample having sizes of 4.5 mm by 20 mm was subjected to TMA measurement in a tension mode, with temperature rising from 40°C to 260°C under conditions at a load of 50 mN and a heating rate of 10°C/min, so that the thermal expansion coefficient (°C/ppm) in the range from 60°C to 120°C was measured.

### <Production of curable resin>

### [Example 1]

In a 500-mL separable flask, 137 g of 1,4-cyclohexane dimethanol, 183 g of diphenyl carbonate and 0.0097 g of titanium (IV) tetrabutoxide were placed, and the mixture was subjected to gradual temperatures rise and pressure reduction under nitrogen flow while stirring, so that polymerization was finally performed at 230°C, and at 0.1 kPa or less. Then, air cooling was performed until the resin temperature decreased to normal temperature. After air cooling, 9.3 g of maleic anhydride was added thereto and temperature was raised to 200°C under nitrogen flow. After disappearance of distillation of water, the pressure was gradually reduced to 13 kPa, and maintained for about 30 minutes. A resin A was then extracted. The resin A had a Tg of 45°C before curing.

### [Comparative Example 1]

In a 500-mLseparable flask, 175 g of D-NDM (a mixture of decahydro-1,4:5,8-dimethanonaphthalene-2,6(7)-dimethanol and decahydro-1,4:5,8-dimethanonaphthalene-2,3-dimethanol at about 1:1), 7.7 g of maleic anhydride, and 0.015 g of tetra-n-butyl titanate were placed. The mixture was gradually heated to 200°C under nitrogen flow while stirring, and held until disappearance of distilled water. Then, the pressure was gradually decreased to 13 kPa, and then held for 30 minutes. The temperature was then cooled to normal temperature. Then, 163 g of diphenyl carbonate was added thereto, and temperature rising and pressure reduction were gradually performed. The polymerization was finally performed at 230°C and under 0.1 kPa or less to obtain a resin B. The resin B had a Tg of 142°C before curing.

### [Comparative Example 2]

A mixture of 151 g of propylene glycol, 93 g of maleic anhydride, and 140 g of phthalic anhydride was heated to 200°C under nitrogen flow while stirring, and held until disappearance of distilled water. Then, the pressure was gradually decreased to 13 kPa, and held for 30 minutes, so that an unsaturated polyester resin C was obtained. The resin C had a Tg of 22°C before curing.

### <Evaluation of curable resin>

### [Example 2]

A glass cloth cut to sizes of 3 cm by 10 cm (ERW320-554A/T, manufactured by Central Glass Fiber Co., Ltd.) was placed in a SUS mold together with a dryblend of 5 g of the resin A and 0.05 g of Perbutyl P (manufactured by NOF CORPORATION), and sandwiched between an Aflex film (manufactured by AGC Inc.) and an SUS plate at the top and bottom. The pressure was gradually applied at 0.6 MPa by a vacuum press, and molding was performed in that state at 200°C for 90 minutes. After molding, cooling was performed. A molded piece was taken out from the mold to make a sample for measuring bending strength. Incidentally, the weight ratio between the glass cloth and the resin was 18:82.

Also, a sample for measuring the copper foil peeling strength was obtained by pressing with use of a copper foil (3EC-M2S-VLP 12 µm, manufactured by MITSUI MINING & SMELTING CO., LTD.) instead of the Aflex film. Incidentally, the copper foil was laminated such that the resin came into contact with a roughened surface.

The results of the bending strength and the copper foil peeling strength are as shown in Table 1.

### [Example 3 and Comparative Examples 3 and 4]

Samples were made in the same manner as in Example 2, except that the type and amount of resins were changed as shown in Table 1. The results of the bending strength and the copper foil peeling strength are as shown in the following Table 1.

**[Table 1]**

| | | Example 2 | Example 3 | Comparative Example 3 | Comparative Example 4 |
|---|---|---|---|---|---|
| Weighing (g) | Resin A | 5 | 1 | 0 | 0 |
| | Resin B | 0 | 0 | 0 | 1 |
| | Resin C | 0 | 4 | 5 | 4 |
| | Perbutyl P | 0.05 | 0.05 | 0.05 | 0.05 |
| Bending strength (MPa) | | 270 | 300 | 140 | 90 |
| Copper foil peeling strength (N) | | 10 | 4 | 2 | 2 |

### [Example 4]

A solution including 11 g of the resin A dissolved in 9 g of styrene was added to 80 g of CBZ-500LM-AS (an unsaturated polyester containing 45% of styrene, manufactured by Japan U-pica Company Ltd.). Then, 0.5 g of PR-CBZ01 (manufactured by Japan U-pica Company Ltd.) was added, and finally 0.8 g of 328E (manufactured by NIHON TOKUSHU TORYO CO., LTD.) was added. With use of the resin solution, 8 sheets of glass clothes (ERW320-554A/T, manufactured by Central Glass Fiber Co., Ltd.) were molded by hand layup molding (at a weight ratio between glass cloth and resin of 50:50). Then, the molding under a load was cured at normal temperature for 24 hours, and then completely cured by heating at 100°C for 2 hours. The cured product was cut into 3 cm by 8 cm to make a sample for measuring bending strength.

The results of bending strength are as shown in the following Table 2.

### [Comparative Example 5]

A sample was prepared in the same manner as in Example 4, except that the composition of components was changed as shown in Table 2. The results of the bending strength are as shown in the following Table 2.

**[Table 2]**

| | | Example 4 | Comparative Example 5 |
|---|---|---|---|
| Weighing (g) | Resin A | 11 | 0 |
| | Styrene | 9 | 0 |
| | CBZ-500LM-AS | 80 | 100 |
| | PR-CBZ01 | 0.5 | 0.5 |
| | 328E | 0.8 | 0.8 |
| Bending strength (MPa) | | 500 | 470 |

### [Example 5]

A carbon fiber sheet cut to sizes of 3 cm by 10 cm (UT70-30, manufactured by Toray Industries, Inc.) was placed in a SUS mold together with a dryblend of 1 g of the resin A, 4 g of the resin C and 0.05 g of Perbutyl P (manufactured by NOF CORPORATION), and sandwiched between an Aflex film (manufactured by AGC Inc.) and an SUS plate at the top and bottom. The pressure was gradually applied at 0.6 MPa by a vacuum press, and molding was performed in that state at 200°C for 90 minutes. After molding, cooling was performed. A molded piece was taken out from the mold to make a sample for measuring bending strength. Incidentally, the weight ratio between the carbon fiber and the resin was 25:75.

The results of the bending strength are as shown in the following Table 3.

### [Comparative Example 6]

A sample was prepared in the same manner as in Example 5, except that the type and amount of the resin was changed as shown in Table 3. The results of the bending strength are as shown in the following Table 3.

**[Table 3]**

| | | Example 5 | Comparative Example 6 |
|---|---|---|---|
| Weighing (g) | Resin A | 1 | 0 |
| | Resin C | 4 | 5 |
| | Perbutyl P | 0.05 | 0.05 |
| Bending strength (MPa) | | 290 | 190 |

### [Example 6]

A solution including 11 g of the resin A dissolved in 9 g of styrene was added to 80 g of CBZ-500LM-AS (manufactured by Japan U-pica Company Ltd.). Then, 0.5 g of PR-CBZ01 (manufactured by Japan U-pica Company Ltd.) was added, and finally 0.8 g of 328E (manufactured by NIHON TOKUSHU TORYO CO., LTD.) was added. With use of the resin solution, 8 sheets of carbon fiber (UT70-30, manufactured by Toray Industries, Inc.) were molded by hand layup molding (at a weight ratio between carbon fiber and resin of 50:50). Then, the molding under a load was cured at normal temperature for 24 hours, and then completely cured by heating at 100°C for 2 hours. The cured product was cut into 3 cm by 8 cm to make a sample for measuring bending strength.

The results of bending strength are as shown in the following Table 4.

### [Comparative Example 7]

A sample was prepared in the same manner as in Example 6, except that the composition of components was changed as shown in Table 4. The results of the bending strength are as shown in the following Table 4.

**[Table 4]**

| | | Example 6 | Comparative Example 7 |
|---|---|---|---|
| Weighing (g) | Resin A | 11 | 0 |
| | Styrene | 9 | 0 |
| | CBZ-500LM-AS | 80 | 100 |
| | PR-CBZ01 | 0.5 | 0.5 |
| | 328E | 0.8 | 0.8 |
| Bending strength (MPa) | | 700 | 680 |

### [Example 7]

A solution including 1.1 g of the resin A dissolved in 0.9 g of styrene was added to 8 g of CBZ-500LM-AS (manufactured by Japan U-pica Company Ltd.). Then, 0.05 g of PR-CBZ01 (manufactured by Japan U-pica Company Ltd.) was added, and finally 0.08 g of 328E (manufactured by NIHON TOKUSHU TORYO CO., LTD.) was added. The resin solution was put in a mold with sizes of 5 cm by 5 cm by 3 mm thick, and cured at normal temperature for 24 hours. Then, the molding was completely cured by heating at 100°C for 2 hours. The cured resin was cut into 1 cm by 5 cm to make a sample for measuring bending strength.

The results of bending strength are as shown in the following Table 5.

### [Comparative Example 8]

To 10 g of CBZ-500LM-AS (manufactured by Japan U-pica Company Ltd.), 0.05 g of PR-CBZ01 (manufactured by Japan U-pica Company Ltd.) was added, and 0.08 g of 328E (manufactured by Nippon Tokushu Toryo Company Ltd.) was added. The resin solution was put in a mold with sizes of 5 cm by 5 cm by 3 mm thick, and cured at normal temperature for 24 hours. Then, the molding was completely cured by heating at 100°C for 2 hours. The cured resin was cut into 1 cm by 5 cm to make a sample for measuring bending strength.

The results of bending strength are as shown in the following Table 5.

**[Table 5]**

| | | Example 7 | Comparative Example 8 |
|---|---|---|---|
| Weighing (g) | Resin A | 1.1 | 0 |
| | Styrene | 0.9 | 0 |
| | CBZ-500LM-AS | 8 | 10 |
| | PR-CBZ01 | 0.05 | 0.05 |
| | 328E | 008 | 008 |
| Bending strength (MPa) | | 115 | 85 |

### [Example 8]

In a 500-mL separable flask, 128 g of 1,4-cyclohexane dimethanol, 70 g of 1,6-hexane diol, 285 g of diphenyl carbonate and 0.015 g of titanium (IV) tetrabutoxide were placed, and the mixture was subjected to gradual temperatures rise and pressure reduction under nitrogen flow while stirring, so that polymerization was finally performed at 230°C, and at 0.1 kPa or less. Then, air cooling was performed until the resin temperature decreased to normal temperature. After air cooling, 14.5 g of maleic anhydride was added thereto and temperature was raised to 200°C under nitrogen flow. After disappearance of distillation of water, the pressure was gradually reduced to 13 kPa, and maintained for about 30 minutes. A resin D was then extracted. The resin D had a Tg of -13°C before curing.

### [Example 9]

Each of the resin A and the resin D was dissolved in methyl ethyl ketone to a content of 25 wt%, placed in a bottle and left stand at 25°C to measure the time until deposition during a period of 1 month. The resin A had a time until deposition of 2 hours, and the resin D had a time until deposition of 1 month or more. From the results, it has been found that inclusion of the structural unit derived from 1,6-hexane diol in a resin improves the solubility of the resin.

### [Example 10]

After weighing 3 g of the resin A, 4.14 g of BMI-2300 (manufactured by Daiwa Kasei Industry Co., Ltd.) and 2.86 g of DABPA (manufactured by Daiwa Kasei Industry Co., Ltd.), 16 g of methyl ethyl ketone was added thereto to dissolve the mixture. About 3 g of the dissolved resin was applied to a glass cloth E2118 (manufactured by Nitto Boseki Co., Ltd.) cut to a 16-cm square. After natural drying, drying at 150°C was performed for 3 minutes, so that a prepreg was obtained. Then, the prepreg was sandwiched between an Aflex film (manufactured by AGC Inc.) and an SUS plate at the top and bottom. The pressure was gradually applied at 0.6 MPa by a vacuum press, and molding was performed in that state at 200°C for 150 minutes. After molding, cooling was performed to make a sample for measuring thermal expansion coefficient.

### [Example 11]

The same procedure was performed as in Example 10, except that the resin D was used instead of the resin A.

### [Comparative Example 9]

After weighing 5.91 g of resin BMI-2300 (manufactured by Daiwa Kasei Industry Co., Ltd.) and 4.09 g of DABPA (manufactured by Daiwa Kasei Industry Co., Ltd.), 16 g of methyl ethyl ketone was added thereto to dissolve the mixture. About 3 g of the dissolved resin was applied to a glass cloth E2118 (manufactured by Nitto Boseki Co., Ltd.) cut to a 16-cm square. After natural drying, drying at 150°C was performed for 3 minutes, so that a prepreg was obtained. Then, the prepreg was sandwiched between an Aflex film (manufactured by AGC Inc.) and an SUS plate at the top and bottom. The pressure was gradually applied at 0.6 MPa by a vacuum press, and molding was performed in that state at 200°C for 150 minutes. After molding, cooling was performed to make a sample for measuring thermal expansion coefficient.

**[Table 6]**

| | Example 10 | Example 11 | Comparative Example 9 |
|---|---|---|---|
| Thermal expansion coefficient (°C/ppm) | 7.6 | 5.6 | 9.2 |

## Claims

1. A curable resin comprising:
a structural unit represented by the following formula (1): 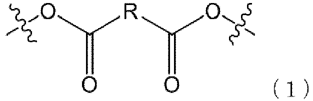
wherein R is a divalent group having an ethylenic double bond and/or an acetylenic triple bond,
a structural unit represented by the following formula (2): 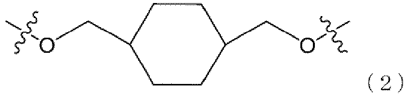
and a structural unit represented by the following formula (3):

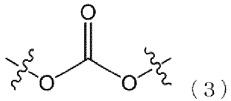

2. The curable resin according to claim 1, wherein the structural unit represented by the formula (1) is derived from at least one selected from the group consisting of fumaric acid, maleic acid and maleic anhydride.

3. The curable resin according to claim 1, having a glass transition temperature of 50°C or less.

4. The curable resin according to claim 1, wherein a molar ratio of the structural unit represented by the formula (1) to the structural unit represented by the formula (2) is 0.01 or more and less than 1.

5. The curable resin according to claim 1, wherein a molar ratio of the structural unit represented by the formula (3) to the structural unit represented by the formula (2) is 0.01 or more and less than 1.

6. The curable resin according to claim 1, wherein a molar ratio of the total of the structural unit represented by the formula (1), the structural unit represented by the formula (2) and the structural unit represented by the formula (3) to all the structural units constituting the curable resin is 0.6 or more.

7. The curable resin according to claim 1, further comprising a structural unit represented by the following formula (4): 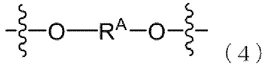 wherein R^{A} is a straight-chain alkylene group.

8. A cured product of the curable resin according to any one of claims 1 to 7.

9. A resin composition comprising the curable resin according to any one of claims 1 to 7.

10. The resin composition according to claim 9, wherein an amount of the curable resin relative to 100 parts by mass of a resin component contained in the resin composition is 1.0 part by mass or more.

11. The resin composition according to claim 9, for use as an electronic material.

12. An electronic component comprising a cured product of the resin composition according to claim 9.

13. A fiber-reinforced composite material comprising the resin composition according to claim 9, and a reinforcement fiber.

14. A fiber-reinforced formed article being a cured product of the fiber-reinforced composite material according to claim 13.

15. A semiconductor sealing material comprising the resin composition according to claim 9 and an inorganic filler.

16. A semiconductor device comprising a cured product of the semiconductor sealing material according to claim 15.

17. A prepreg comprising a base material and the resin composition according to claim 9 that is impregnated into or applied to the base material.

18. A laminate comprising the prepreg according to claim 17.

19. A circuit board comprising the laminate according to claim 18 and a metal foil disposed on one or both surfaces of the laminate.

20. A buildup film comprising a cured product of the resin composition according to claim 9 and a base material film.
